# DEMANDE DE BREVET EUROPEEN

(11) **EP 3 125 660 A1**
(43) Date de publication de la demande: **01.02.2017**
(21) Numéro de dépôt: 16315005.5
(22) Date de dépôt: 13.07.2016
(51) Int. Cl.: H05K 13/00, H05K 13/04, H01L 21/67

(54) **DISPOSITIF DE MANIPULATION DE PETITS OBJETS**

(30) Priorité: 29.07.2015 FR 1501628
(71) Demandeur: JFP Microtechnic, 91460 Marcoussis (FR)
(72) Inventeur: Palomares, Jean-Baptiste, 89410 Cezy (FR); Palomares, François, 78530 Buc (FR)
(74) Mandataire: Flavenot, Bernard

(57) **Abrégé**

La présente invention concerne les dispositifs de manipulation de petits objets

Le dispositif selon l'invention comporte une embase 1, deux platines 2 et 3, deux pignons 4, 6, couplés entre eux en rotation sur l'embase 1 autour respectivement des axes 5 et 7, un moteur 8, une butée 9 réalisée excentrée sur le pignon 4, une contrebutée 10 réalisée sur la platine 2, la platine 2 étant en translation selon la direction 11 de façon en outre que la contrebutée 10 soit au contact avec la butée 9, une butée 12 située excentrée sur le pignon 6, contrebutée 13 réalisée sur ladite seconde platine 3, la platine 3 étant en translation selon une direction 15 par rapport à la platine 2, la direction 15 faisant par rapport à la direction 11 un angle non nul et perpendiculaire au second axe 7, la seconde contrebutée 13 étant au contact avec la butée 12, et des moyens de préhension 14 aptes à saisir des objets et montés en coopération avec la platine 3.

Application à la manipulation notamment de petits composants électroniques comme des puces ou analogues

## Description

La présente invention concerne les dispositifs pour manipuler des petits objets, par exemple des petits composants de toute nature, composants mécaniques, CMS (Composants Montés en Surface), MEMS (en anglais : Microelectromechanical Systems), composants micro-électroniques de quelques millimètres à quelques dizaines de microns tels que des puces électroniques ou analogues.

Pour de nombreuses industries, et dans tous les domaines, il est souvent nécessaire de prélever des petits objets et de les poser de façon très précise sur un support pour les y fixer par tous moyens, notamment par collage, soudure thermique, laser, ultrasons, etc..

En outre, ces opérations doivent s'effectuer de façon répétitive, même si elles ne sont pas effectuées un nombre de fois qui soit de l'ordre de grandeur nécessaire pour des productions de masse. Tel est par exemple le cas, dans les centres de recherche, les services de mise au point ou de réalisation de préséries de produits avant le passage au stade industriel.

Aussi, pour respecter toutes les conditions d'un bon positionnement, par exemple d'un composant électronique comme une puce ou analogue, a-t-il déjà été réalisé des dispositifs particuliers, notamment des équipements avec une loupe binoculaire ou caméra sous laquelle s'effectuent les opérations de prélèvement et de pose.

De tels dispositifs sont déjà connus, par exemple ceux décrits dans les FR-A-2875967, FR-A-2840763, EP-0877844, US-6185815, et DE-196 10294.

Ces équipements peuvent donner de très bons résultats, mais présentent néanmoins des inconvénients. En effet, la vision binoculaire entraîne toujours un défaut de parallaxe plus ou moins important qui rend la précision du prélèvement des objets et de leur pose tributaire de l'expérience de l'opérateur pour interpréter l'image donnée par la loupe. Le grossissement d'image est généralement limité à 40 fois, ce qui rend encore plus difficile le positionnement des composants de très petites dimensions, par exemple de l'ordre de 200 à 300 microns. De plus, la plaquette distributrice des objets et la plaquette réceptrice de ces objets sont liées sur le même moyen de transfert, ce qui limite les possibilités de répétitivité et de rendement.

Il existe aussi un dispositif comme celui qui est décrit dans le FR-A-2 977 756 au nom de la Demanderesse, mais qui n'a été conçu que pour une application particulière.

Aussi, la présente invention a-t-elle pour but de réaliser un dispositif de manipulation de petits objets, par exemple de petits composants de toute nature, composants mécaniques, CMS, MEMS, composants micro-électroniques de quelques millimètres à quelques dizaines de microns, qui pallie les inconvénients mentionnés ci-dessus des dispositifs en ce domaine selon l'art antérieur, tout en étant présentant une structure très simple, qui soit d'une utilisation facile, fiable, sûre, parfaitement répétitive, facilement adaptable, etc., et qui en plus permette d'obtenir un rendement très supérieur à celui permis avec les dispositifs antérieurs du même type.

Plus précisément, la présente invention a pour objet un dispositif de manipulation de petits objets, notamment du type composants électroniques, comportant les caractéristiques telles que celles définies au moins dans la revendication 1 annexée.

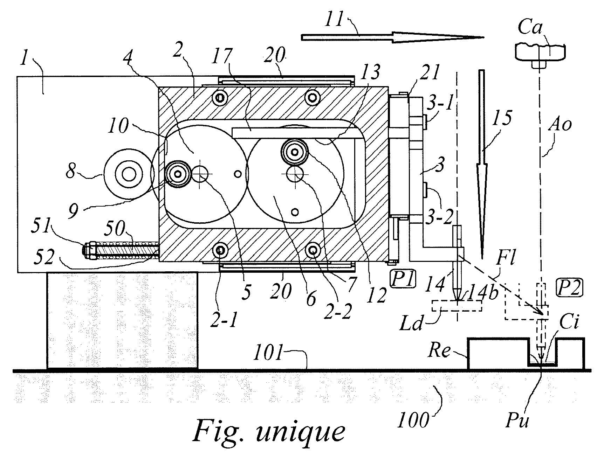

D'autres caractéristiques et avantages de la présente invention apparaîtront au cours de la description suivante donnée en regard du dessin annexé à titre illustratif mais nullement limitatif, dans lequel la figure unique représente, en vue de côté et partiellement en écorché, un mode de réalisation du dispositif de manipulation de petits objets selon l'invention.

Il est tout d'abord précisé que si, dans la présente description, l'adverbe "sensiblement" est associé à un qualificatif d'un moyen donné, ce qualificatif doit être compris au sens strict ou approché.

La présente invention concerne un dispositif de manipulation de petits objets Ci, du type de ceux définis au préambule de la présente description, en vue, par exemple, de les déposer en un endroit déterminé tel que le fond d'un puits Pu réalisé dans un réceptacle Re.

Le dispositif comporte, notamment en référence à la figure unique, une embase 1, une première platine 2, une seconde platine 3, un premier pignon 4, des premiers moyens pour monter ce premier pignon en rotation par rapport à l'embase 1 autour d'un premier axe 5, un second pignon 6, des seconds moyens pour monter le second pignon en rotation par rapport à l'embase 1 autour d'un second axe 7 parallèle au premier axe 5, des moyens pour coupler entre eux en rotation synchronisée ces deux pignons 4, 6, et un moteur d'entraînement 8 pour commander en rotation l'un des deux pignons 4, 6, en l'occurrence le pignon 4 dans le mode de réalisation illustré.

De façon préférentielle, les premier et second pignons 4, 6 sont des pignons à entraînement par engrenage l'un avec l'autre, par exemple par dentures ou analogues, et le moteur 8 comporte par exemple un pignon d'entraînement monté sur l'arbre menant couplé, comme illustré, sur le pignon 4, par tout moyen.

Tous ces éléments et moyens mentionnés ci-dessus sont bien connus en eux-mêmes, et ne seront donc pas plus amplement définis ici, dans l'unique souci de simplifier la présente description.

Le dispositif comporte en outre une première butée 9 réalisée excentrée sur le premier pignon 4 et une première contrebutée 10 réalisée sur la première platine 2. Cette première contrebutée est constituée, lorsque la platine est constituée dans sa forme générale d'une plaque ou analogue, d'une portion du bord d'une découpe réalisée dans l'épaisseur de cette plaque, comme visible et illustré sur la figure.

La butée 9 peut être constituée d'un doigt ou d'un ergot en saillie sur le pignon, mais avantageusement d'un galet pivotant, pour favoriser le déplacement relatif de la contrebutée 10 sur cette butée 9, comme il sera explicité ci-après.

Le dispositif comporte en outre des premiers moyens pour monter la première platine 2 en translation selon une première direction 11 par rapport à l'embase 1 et perpendiculairement au premier axe 5, de façon en outre que la première contrebutée 10 soit apte à être, ou venir au contact, de la première butée 9 quelle que soit la position de cette première butée quand le pignon 4 tourne, bien que, selon une autre caractéristique de l'invention comme explicité ci-après, la première contrebutée 10 et la première butée 9 pourront ne plus être au contact au cours d'une partie de la rotation de ce pignon.

Il est en outre prévu une seconde butée 12 située excentrée sur le second pignon 6, du même type que la première butée 9 définie ci-dessus, une seconde contrebutée 13 réalisée sur la seconde platine 3, par exemple comme illustré une tige rigide 17 ou analogue, et des seconds moyens pour monter cette seconde platine 3 en translation selon une seconde direction 15 par rapport à la première platine, cette seconde direction 15 faisant par rapport a la première direction 11 un angle non nul, de préférence un angle sensiblement égal à quatre-vingt-dix degrés, comme sur la figure.

Cette seconde direction est définie pour être perpendiculaire au second axe 7 et de façon en outre que la seconde contrebutée 13 soit apte à être, ou venir au contact, de la seconde butée 12 quelle que soit la position de cette seconde butée quand le second pignon 6 tourne, bien que, selon une autre caractéristique de l'invention comme explicité ci-après, la seconde contrebutée 13 et la seconde butée 12 pourront ne plus être au contact au cours d'une partie de la rotation de ce pignon.

Selon une réalisation particulièrement avantageuse notamment du fait de sa simplicité et son faible coût de revient, les premiers moyens pour monter la première platine 2 en translation selon une première direction 11 par rapport à l'embase 1 et les seconds moyens pour monter la seconde platine 3 en translation selon une seconde direction 15 par rapport à la première platine sont constitués par des glissières, de préférence à roulements à billes ou analogues.

Le dispositif comporte en outre des moyens de préhension 14 aptes à saisir des objets et montés en coopération avec la seconde platine 3.

Ces moyens de préhension 14 sont très préférentiellement constitués par une bouche d'aspiration 14b apte à être connectée à une pompe à vide (non représentée) et des moyens (non représentés) pour éventuellement translater la bouche d'aspiration selon la seconde direction 15 définie ci-avant.

A un tel dispositif est généralement associée une ligne de distribution des objets Ci qui n'a pas été représentée, seulement évoquée en Ld en traits interrompus, car elle n'entre pas dans le cadre de l'invention, mais qui ne présente aucune difficulté de réalisation et d'association avec le dispositif.

Selon une autre caractéristique importante de l'invention, pour un bon fonctionnement fiable et répétitif du dispositif, ce dernier comporte en outre des premiers moyens pour tendre à maintenir constamment la première contrebutée 10 au contact de la première butée 9, et des seconds moyens pour tendre à maintenir aussi constamment la seconde contrebutée 13 au contact de la seconde butée 12.

Selon une réalisation préférentielle du fait de sa simplicité et de son très faible coût de revient, les premiers moyens pour tendre à maintenir la première contrebutée 10 au contact de la première butée 9 sont constitués avantageusement par des moyens pour créer une force élastique constante sur la première platine 2, ces derniers moyens étant avantageusement constitués d'un ressort 50 de tout type, par exemple hélicoïdal comme illustré, monté en compression en prenant appui, à une de ses extrémités sur un point 51 de l'embase 1, et à son autre extrémité sur un point 52 de la première platine 2 et donc en conséquence sur la première contrebutée 10 qui de ce fait à tendance à rester constamment au contact de la butée 9, si rien ne l'en empêche comme il sera explicité ci-après.

Quant aux seconds moyens pour tendre à maintenir la seconde contrebutée 13 au contact de la seconde butée 12, ils sont très avantageusement constitués par le fait que la seconde platine 3 est positionnée de façon que la seconde direction 15 ait au moins une composante non nulle selon la direction de la force de gravitation, et donc que cette force de gravitation s'applique sur la seconde platine 3 et en conséquence sur la tige 17 qui, de ce fait, a tendance à rester constamment au contact de la butée 12, si rien ne l'en empêche comme il sera explicité ci-après.

Bien que la réalisation décrite ci-dessus soit préférée, il est à noter que, selon les besoins des utilisateurs, la force de gravitation pourrait être remplacée par un autre ressort en compression comme le ressort 50.

Aussi, de façon tout à fait préférentielle, l'embase est agencée de façon à être apte à être positionnée sur un plan 101 sensiblement horizontal d'un support 100, de façon que la seconde direction 15 soit sensiblement perpendiculaire à ce plan horizontal et que la force de gravitation s'applique sur la seconde platine 3 pour la translater automatiquement vers le bas quand la butée 12 passe de sa position haute, comme illustré, à sa position basse après un demi-tour du pignon 6, cette position basse n'ayant pas été illustrée.

En fait, comme il sera explicité ci-après, les deux platines coopèrent avec leur pignon respectif 4, 6 au moyen des butées 9, 12 et contrebutées 10, 13 de façon qu'elles soient aptes à se translater d'une amplitude maximale définie par les deux positions extrêmes diamétralement opposées des butées 9, 12 quand les pignons 4, 6 font un demi-tour autour de leur axe de rotation respectif, selon la direction 11 pour le pignon 4 et selon la direction 15 pour le pignon 6.

La figure représente la position extrême vers gauche de la première platine 2 et la position extrême vers le haut de la seconde platine 3. Les autres positions extrêmes, non illustrées, sont : pour la platine 2, vers la droite quand la butée 9 prend une position diamétralement opposée à celle illustrée sur la figure, et pour la platine 3, tout en bas quand la butée 12 prend une position diamétralement opposée à celle illustrée sur cette même figure.

Avec la combinaison des deux translations respectives des deux platines 2, 3, il est possible de faire passer les moyens de préhension 14, de la position P1 (en traits continus) à la position P2 (en traits interrompus) qui est, dans ce mode de réalisation illustré, à un niveau inférieur à la position P1, et réciproquement.

Un tel dispositif est utilisé pour déposer des objets Ci par exemple identiques successivement sur des réceptacles Re en théorie tous identiques.

Mais, du fait par exemple des tolérances de fabrication, ces réceptacles Re ne sont en réalité pas tous strictement identiques. Aussi est-il nécessaire, avant de déposer un objet Ci sur un réceptacle, de vérifier la position de l'endroit où il doit être déposé.

Cette vérification est largement favorisée par la structure du dispositif car, lorsqu'ils sont dans leur position P1, les moyens de préhension 14 ne sont pas dans l'axe optique Ao par exemple d'une caméra Ca ou loupe binoculaire prévue pour contrôler la position de l'endroit du réceptacle Re où l'objet Ci doit être précisément déposé.

Cependant, en vue de faciliter les opérations de pose d'objets identiques Ci en un même endroit déterminé de réceptacles théoriquement identiques, le dispositif comporte en outre des moyens pour définir la position P2 des moyens de préhension 14 pour leur pose sur le réceptacle Re, pour chaque couple objet-réceptacle donné.

Ces moyens sont constitués par des premiers moyens de butée de fin de course réglables pour limiter la translation de la première platine 2, et des seconds moyens de butée de fin de course réglables pour limiter la translation de la seconde platine 3.

Ces moyens de butée de fin de course réglables peuvent être réalisés de différentes façons. Ils ont été simplement évoquées schématiquement par les ensembles référencés 2-1, 2-2 et 3-1 3-2. Leur réalisation ne présente pas de problèmes particuliers pour un homme du métier et le mode de réalisation représenté sur la figure n'est qu'un exemple indicatif.

Ainsi, en réglant de façon très aisée, par exemple au moyen de micro-vis ou analogues, ces butées de fin de course 2-1, 2-2 et 3-1, 3-2, les platines seront parfaitement stoppées dans leur translation à un endroit prédéterminé, avant que leur pignon associé ait fait un demi-tour complet, permettant ainsi de définir des positions limites parfaitement définies pour ces deux platines, et donc en conséquence la position P2 pour les moyens de préhension 14 adaptée au couple objet-réceptacle donné.

Il est mentionné que le réceptacle Re est très avantageusement fixé sur le support 100 via un plateau ou analogue (non représenté) qui est apte à être déplacé, par exemple en X et Y, par rapport à ce support 100, au moyen de vis micrométriques ou analogues. Un tel plateau est connu en lui-même et ne sera donc pas plus amplement décrit ici, d'autant plus qu'il n'entre pas dans le cadre de l'invention.

Le dispositif selon l'invention dont un mode de réalisation est décrit ci-dessus fonctionne de la façon suivante :
On suppose tout d'abord qu'un réceptacle Re est destiné à recevoir, au fond d'un puits Pu, un objet Ci, par exemple une puce ou analogue. Ce réceptacle Re est fixé par tous moyens sur le plan 101 du support 100, l'ouverture du puits Pu étant tournée vers le haut. La puce Ci est plaquée par aspiration sur la bouche 14b à la sortie de la ligne de distribution Ld.

Les platines 2, 3 sont initialement pré-positionnées, par exemple manuellement, de façon que la puce Ci, maintenue sur la bouche 14b, soit amenée à l'endroit exact où elle doit être déposée au fond du puits Pu. Les butées de fin de course 2-1, 2-2 et 3-1, 3-2 des deux platines sont alors réglées, puis bloquées.

Lorsque les butées de fin de course sont ainsi définies, la bouche 14b sera répétitivement parfaitement positionnée au même endroit et pourra répétitivement déposer, à l'endroit voulu, des puces Ci identiques sur des réceptacles identiques.

Cette opération répétitive est alors effectuée de façon partiellement automatique en commandant, pour chaque pose d'une puce Ci, le moteur 8 qui entraîne la rotation des deux pignons 4, 6 couplés entre eux comme explicité auparavant, les butées coopérant avec les contrebutées (couples 9/10 et 12/13) comme aussi décrit ci-avant.

Cependant, après la pose d'une puce sur un réceptacle, après le remplacement de ce dernier par un nouveau réceptacle et avant la pose d'une nouvelle puce Ci, il est procédé à la vérification de la position de l'endroit où elle doit être déposée, à l'aide de la caméra Ca ou analogue. Si le réceptacle n'est pas tout à fait correctement positionné, sa position sera ajustée par rapport à la position P2 des moyens de préhension 14 en déplaçant de façon connue le plateau en X, Y de façon micrométrique.

On suppose, pour la clarté de l'explication du fonctionnement, que la position initiale respectivement des deux platines 2, 3 est celle illustrée sur la figure.

A la commande du moteur 8, les pignons 4, 6, couplés entre eux, entraînent en rotation les butées 9, 12 qui se déplacent en décrivant une trajectoire circulaire centrée sur l'axe de rotation 5, 7 respectivement des deux pignons, les deux mouvements circulaires permettant à la platine 2 de se translate vers la droite sous l'action du ressort 50, et la platine 3 de descendre sous l'action de la force de gravitation.

Dans ces mouvements des deux platines qui se combinent, la bouche 14b se déplace sensiblement comme indiqué par la flèche Fl, en précisant que la flèche Fl n'est pas obligatoirement la trajectoire réelle suivie par la bouche 14b, cette trajectoire pouvant en fait être courbe (selon les dimensions, le couplage des pignons, les positions des butées 9, 12, etc.), la flèche Fl n'étant alors dans ce cas qu'une corde de cette trajectoire courbe.

La translation des deux platines est stoppée dès qu'elles butent contre leurs butées de fin de course 2-1, 2-2 et 3-1, 3-2 respectives, avant même que les pignons aient complétement effectué un demi-tour sur eux-mêmes.

Ce résultat est dû au préréglage effectué sur les butées de fin de course 2-1, 2-2 et 3-1, 3-2 comme il a été explicité ci-dessus.

Les pignons continuent à tourner, ainsi que les butées 9, 12 mais sans que les contrebutées soient à leur contact. Après une certaine rotation, ces butées 9, 12 reviennent au contact des contrebutées 10, 13 et leur font subir une translation opposée à la précédente qui les ramène à leur position définie comme origine, ce qui repositionne la bouche 14b à sa position P1 après avoir suivi un trajet inverse à celui défini par la flèche Fl. La bouche 14b est prête à ressaisir une nouvelle puce Ci et à la poser sur un autre réceptacle Re.

Il est précisé que, selon un mode de réalisation souvent préféré, la butée de fin de course 3-1, 3-2 pour la seconde platine 3 qui peut être réalisée de différentes façons est constituée par la combinaison de l'objet Ci (3-1) plaqué par aspiration sur la bouche 14b et du réceptacle Re lui-même (3-2). De cette façon, il est certain que l'objet Ci va bien venir au contact du réceptacle Re, à l'endroit où il est prévu de le déposer. De ce fait, les deux positions diamétralement opposées de la seconde butée 12 sont distantes l'une de l'autre d'une valeur supérieure à la course possible de la seconde platine 3 et donc des moyens de préhension 14.

Les opérations décrites ci-dessus peuvent se faire de façon continue ou "pas à pas", de façon réplétive ou non, selon les besoins, avantageusement de façon automatisée avec une unité de gestion, ou même en commande manuelle si l'utilisateur le veut.

## Revendications

1. Dispositif de manipulation de petits objets, notamment du type composants électroniques, comportant :
• une embase (1),
• une première platine (2),
• une seconde platine (3),
• un premier pignon (4),
• des premiers moyens pour monter le premier pignon en rotation par rapport à ladite embase (1) autour d'un premier axe (5),
• un second pignon (6),
• des seconds moyens pour monter le second pignon en rotation par rapport à ladite embase (1) autour d'un second axe (7) parallèle au premier axe (5),
• des moyens pour coupler entre eux en rotation synchronisée les deux dits pignons (4, 6),
• un moteur d'entraînement (8) pour commander en rotation l'un des deux pignons (4, 6),
• une première butée (9) réalisée excentrée sur ledit premier pignon (4),
• une première contrebutée (10) réalisée sur ladite première platine (2),
• des premiers moyens pour monter ladite première platine (2) en translation selon une première direction (11) par rapport à ladite embase (1), et perpendiculairement au dit premier axe (5), de façon en outre que la première contrebutée (10) soit apte à être au contact avec ladite première butée (9),
• une seconde butée (12) située excentrée sur ledit second pignon (6),
• une seconde contrebutée (13) réalisée sur ladite seconde platine (3),
• des seconds moyens pour monter ladite seconde platine (3) en translation selon une seconde direction (15) par rapport à ladite première platine, ladite seconde direction (15) faisant par rapport à la première direction (11) un angle non nul en étant en outre perpendiculaire au second axe (7) et, de façon en outre que la seconde contrebutée (13) soit apte à être au contact avec ladite seconde butée (12), et
• des moyens de préhension (14) aptes à saisir des objets et montés en coopération avec ladite seconde platine (3).

2. Dispositif selon la revendication 1, **caractérisé par le fait qu'**il comporte en outre des premiers moyens pour tendre à maintenir la première contrebutée (10) au contact de la première butée (9) et des seconds moyens pour tendre à maintenir la seconde contrebutée (13) au contact de la seconde butée (12).

3. Dispositif selon la revendication 2, **caractérisé par le fait que** les premiers moyens pour tendre à maintenir la première contrebutée (10) au contact de la première butée (9) sont constitués par des moyens pour créer un force élastique entre la première platine (2) et la première butée (9), et **par le fait que** les seconds moyens pour tendre à maintenir la seconde contrebutée (13) au contact de la seconde butée (12) sont constitués **par le fait que** la seconde platine (3) est positionnée de façon que la seconde direction (15) ait au moins un composante non nulle selon la force de gravitation.

4. Dispositif selon l'une des revendications précédentes, **caractérisé par le fait qu'**il comporte en outre des premiers moyens de butée de fin de course réglables (2-1, 2-2) pour limiter la translation de la première platine, et des seconds moyens de butée de fin de course réglables (3-1, 3-2) pour limiter la translation de la seconde platine.

5. Dispositif selon l'une des revendications précédentes, **caractérisé par le fait que** les premiers moyens pour monter ladite première platine (2) en translation selon une première direction (11) par rapport à ladite embase (1) et les seconds moyens pour monter ladite seconde platine (3) en translation selon une seconde direction (15) par rapport à ladite première platine sont constitués par des glissières.

6. Dispositif selon l'une des revendications précédentes, **caractérisé par le fait que** les première et seconde butées (9, 12) sont constituées par des galets rotatifs.

7. Dispositif selon l'une des revendications précédentes, **caractérisé par le fait que** les moyens de préhension (14) sont constitués par une bouche d'aspiration (14b) apte à être connectée à une pompe à vide.

8. Dispositif selon l'une des revendications précédentes, **caractérisé par le fait que** la première direction (11) et la seconde direction (15) font entre elles un angle sensiblement égal à quatre-vingt-dix degrés.

9. Dispositif selon la revendication 8, **caractérisé par le fait que** l'embase est agencée de façon à être apte à être positionnée sur un plan de support (100) sensiblement horizontal, de façon que la seconde direction (15) soit sensiblement perpendiculaire à ce plan horizontal

10. Dispositif selon l'une des revendications précédentes, **caractérisé par le fait que** les premier et second pignons (4, 6) sont des pignons à entraînement par engrenage l'un avec l'autre.
